# EUROPEAN PATENT APPLICATION

(11) **EP 4 687 234 A1**
(43) Date of publication of application: **04.02.2026**
(21) Application number: 24201637.6
(22) Date of filing: 20.09.2024
(51) Int. Cl.: H01S 5/10, H01S 5/20, H01S 5/34, H01S 5/16

(54) **REFRACTIVE INDEX ENGINEERING FOR BRIGHTNESS ENHANCEMENT AND KINK SUPPRESSION IN OPTICAL EMITTING DEVICES**

(30) Priority: 31.07.2024 US 202418790359
(71) Applicant: II-VI Delaware, Inc., Wilmington, DE 19890 (US)
(72) Inventor: OLIVA, Nicolo, Wilmington, 19890 (US); TODT, Rene, Wilmington, 19890 (US); ZEGHUZI, Anissa, Wilmington, 19890 (US)
(74) Representative: Schmidt, Christian

(57) **Abstract**

Systems and methods are provided for refractive index engineering for brightness enhancement and kink suppression in optical emitter devices. An example optical emitter device may include a first region that includes a first semiconductor material, an active region located on the first region, with the active region including a pumped active region between a front end and a back end of the optical emitter device, and a plurality of loss structures arranged along at least a portion of at least one side of the pumped active region. The plurality of loss structures may be arranged between the front end and the back end of the optical emitter device. The plurality of loss structures may include two or more continuous etched lines. The plurality of loss structures may include two or more discontinuous etched features.

## Description

### TECHNICAL FIELD

Aspects of the present disclosure relate to optical communication based solutions. More specifically, certain implementations of the present disclosure relate to methods and systems for implementing and utilizing refractive index engineering for brightness enhancement and kink suppression in optical emitter devices.

### BACKGROUND

Limitations and disadvantages of conventional solutions for implementing and using optical emitter devices, particularly edge emitting devices, will become apparent to one of skill in the art, through comparison of such systems with some aspects of the present disclosure as set forth in the remainder of the present application with reference to the drawings.

### BRIEF SUMMARY

System and methods are provided for refractive index engineering for brightness enhancement and kink suppression in optical emitter devices, substantially as shown in and/or described in connection with at least one of the figures, as set forth more completely in the claims.

These and other advantages, aspects and novel features of the present disclosure, as well as details of an illustrated embodiment thereof, will be more fully understood from the following description and drawings.

### BRIEF DESCRIPTION OF THE DRAWINGS

Fig. 1 illustrates an example optical emitter device with non-absorbing mirror (NAM) and process for making thereof.
Fig. 2 illustrates an example optical emitter device with non-absorbing mirror (NAM) as viewed from the top, showing various details thereof.
Fig. 3 illustrates an example optical emitter device with non-absorbing mirror (NAM) and loss structures.
Fig. 4 illustrates different example loss structures that may be used in optical emitter devices with non-absorbing mirror (NAM).
Figs. 5A-5B are graphs illustrating optical power performance of example optical emitter devices with no refractive index engineering on emitter sides.
Figs. 6A-6B are graphs illustrating optical power performance of example optical emitter devices with patterned refractive index variations on emitter sides.
Fig. 7 is a graph illustrating improvements in slow axis performance when using loss structures.
Fig. 8 is a graph illustrating improvements in brightness performance when using loss structures.

### DETAILED DESCRIPTION

The present disclosure is directed to optical emitter devices (e.g., laser emitters), and solutions for improving operation and/or performance thereof. In particular, embodiments based on the present disclosure are directed to, and/or incorporate use of, refractive index (RI) engineering for brightness enhancement and kink suppression in optical emitter devices, particularly edge emitting lasers.

In this regard, certain optical emitter devices may have some shortcomings or issues, particularly with respect to such aspects as brightness and/or power kinks. For example, wide multi-mode edge emitting lasers may be required to operate and/or provide power at higher levels to enable use in certain applications, such as industrial and lidar applications. This may be done by, e.g., increasing emitter width. However, the increase in emitter width may cause some issues and/or raise some challenges. For example, with the increase of the emitter width, brightness of the lasers may degrade and kinks (discontinuities) in the optical power may occur. In this regard, brightness is a key performance for a laser, expressing the amount of optical power emitted over a certain angle. The brighter the laser, the larger is the fraction of the total power emitted that can be easily collected by the module optic elements. As such, degradation in brightness is undesired. Similarly, the presence of power kinks is undesired. In this regard, the presence of kinks in the output power of a laser may render the laser substantially useless for operation since the provided power could be unstable over time. Moreover, discontinuities in the optical power constitute a reliability risk for the device. Hence, it is desirable to have solutions that address these issues, and to do so without compromising or otherwise affecting the performance of the optical emitter devices.

Conventional solutions, if any exist, for addressing these issues may have shortcomings and/or limitations, however. For example, solutions directed to kink suppression do not address brightness, and additionally may cause additional issues such as causing far field instabilities, high far field divergence at low currents, and/or burn-in (BI) fails, and/or may have disadvantages with respect to cost and yield, particularly solutions entailing decreasing fill factor results in a reduced number of chips per wafer.

With respect to solutions directed to brightness enhancement, one approach may be the use of increased emitter length. However, such an approach may have disadvantages with respect to cost and yield, particularly since increasing emitter length results in a reduced number of chips per wafer. Other approaches may include use of lateral trenches for index guiding, and/or use of phase structures added to front and back facet. However, such approaches may not address kink suppression related issues.

Accordingly, it is desirable and preferable to have solutions that address both issues (brightness enhancement and kink suppression), while also eliminating and/or otherwise mitigating disadvantages of any conventional solutions.

Proposed solutions based on the present disclosure are directed to solving both the brightness degradation and the power kinks emergence, and doing so in an improved manner-e.g., without decreasing the fill-factor, or conversely while maintaining adequate brightness and kink-free behavior even for high fill-factor designs. In accordance with the present disclosure, optical emitter devices may be designed and/or modified, for example, to allow for engineering of the refractive index on the sides of the light emitting part (e.g., laser emitter) in order to introduce losses for the higher order modes that are responsible for the presence of kinks in the device's light-current (LI) curve, and which negatively impact brightness. In this regard, several techniques may be used to introduce the necessary refractive index changes, such as by configuring or modifying the etching of active regions, or selective removal of the quantum well (QW) together with overgrowth (e.g., when using non-absorbing mirror (NAM) technology, which may be used as well for front and back facets).

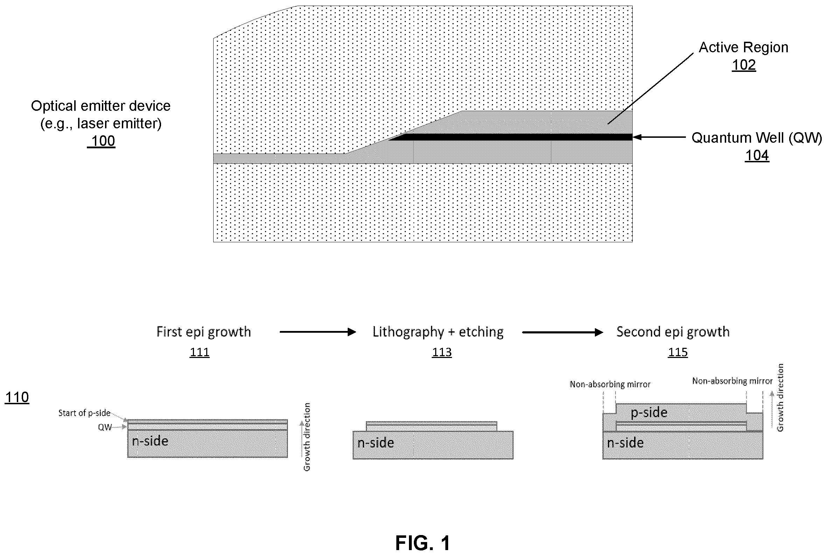

In various example embodiments based on the present disclosure, optical emitter devices may incorporate structures (referred to hereinafter as "loss structures") configured to introduce sufficient losses to achieve both kink-suppression and brightness enhancement. Such loss structures may be configured (e.g., by setting or modifying various characteristics and/or aspects thereof) for achieving the desired improvement with respect to enhanced brightness and kink suppression, and doing so in a manner that does not increase cost or decrease yield, nor compromise overall performance of the optical emitter devices. Such example embodiments and features related thereto are described in more detail below, with respect to Figs. 1-8.

Fig. 1 illustrates an example optical emitter device with non-absorbing mirror (NAM) and process for making thereof. Shown in Fig. 1 are an optical emitter device 100 and a process flow 110.

The optical emitter device 100 may be a quantum-well (QW) based edge-emitting laser device, which may be in the form of a chip or bar. The optical emitter device 100 may comprise a substrate (not shown), and an active region 102 that may comprise an n-side portion which may comprise n-type semiconductor material, one or more quantum wells 104 on top of the n-side portion, and a p-side portion that comprises p-type semiconductor material, which is located on the one or more quantum wells 104. The optical emitter device 100 further comprises one or more non-absorbing mirrors (NAMs). In this regard, non-absorbing mirrors (NAMs) may be incorporated to reduce absorption at the facets, non-radiative recombination, bandgap shrinkage, and catastrophic optical damage (COD).

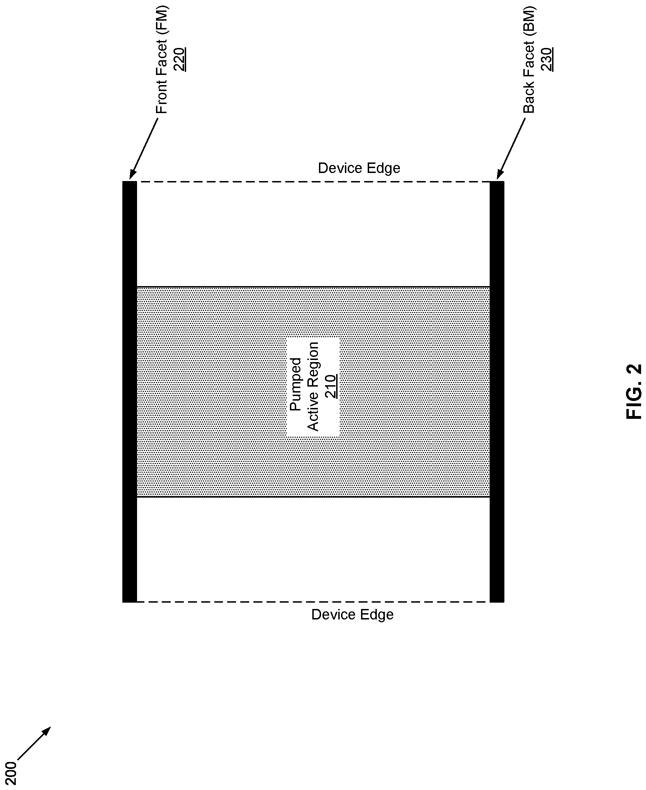

The process flow 110 illustrates an example process for adding non-absorbing mirrors (NAMs), particularly when forming a NAM based device (e.g., the optical emitter device 100). In step 111, a first epi growth may be done, providing an n-side region having a quantum-well (QW) layer grown on top thereof, and then a start of p-side region grown on top of the QW layer. To add the non-absorbing mirrors (NAMs), growth may be interrupted after QW(s) and the beginning of the waveguide are added. In this regard, in step 113 lithography and etching are done to define the regions where the NAMs are to be added. Then, in step 115, a second epi growth may be done, to form the NAMs. In this regard, the QW may be etched at facet sides and on emitter sides to define the NAMs, and then the rest of the p-side portion (epi) is grown on the entire wafer, resulting in NAMs on the front and back of the device-e.g., light (laser) may be emitted to the sides (right and left of the device as illustrated in process flow 110). The resulting refractive index change between NAM and no-NAM regions may be significant-e.g., Δn_{eff} = 3e⁻³. A top view of an optical emitter device incorporating non-absorbing mirrors (NAMs) is illustrated in Fig. 2.

Fig. 2 illustrates an example optical emitter device with non-absorbing mirror (NAM) as viewed from the top, showing various details thereof. Shown in Fig. 2 is an optical emitter device 200.

The optical emitter device 200 may comprise non-absorbing mirrors (NAMs). In this regard, the optical emitter device 200 may be substantially similar to the optical emitter device 100 of Fig. 1. In particular, illustrated in Fig. 2 is a top view of the optical emitter device 200-that is, the optical emitter device 200 as viewed from the top.

The optical emitter device 200 may comprise an active region having or forming a pumped active region 210, which is interrupted-that is, where the active region of the device is removed (as described with respect to the process flow 110) at the front-that is, at the front facet (or "FM") 220, and at the back-that is, the back facet (or "BM") 230, to form non-absorbing mirrors (NAMs). Each of the FM 220 and BM 230 may be, e.g., ~10 µm.

In accordance with the present disclosure, optical emitter devices (e.g., the optical emitter devices 100, 200) may be modified to incorporate refractive index (RI) based engineering related modifications for brightness enhancement and kink suppression. In various embodiments, such RI based engineering related modifications may comprise incorporating loss structures configured for enabling brightness enhanced and kink suppression. For example, in optical emitter devices incorporating non-absorbing mirrors (NAMs), these structures may be side loss structures, incorporating between the NAMs, and along the sides of the pumped active region 210. Examples of such embodiments and various features or aspects related thereto are described in more detail below.

Nonetheless, while various implementations described herein are directed to optical emitter devices incorporating non-absorbing mirrors (NAMs), the disclosure is not limited to such device, and solutions based on the present disclosure may be applied to any suitable optical emitter device. In this regard, similar results as described herein may be achieved by introducing a refractive index (RI) based control by means other than the removal of the QW followed by overgrowth, such as by etching the features in the topside of the emitter devices without any overgrowth.

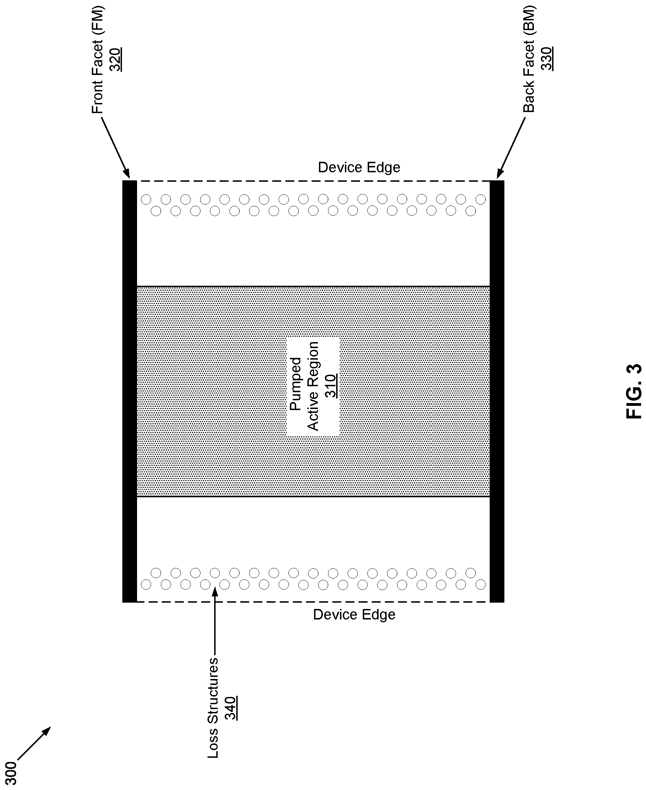

Fig. 3 illustrates an example optical emitter device with non-absorbing mirror (NAM) and loss structures. Shown in Fig. 3 an optical emitter device 300.

The optical emitter device 300 may be substantially similar to the optical emitter devices 100 and 200 as described herein, and thus may comprise non-absorbing mirrors (NAMs). As such, the optical emitter device 300 may comprise an active region, with a quantum well (QW), with the active region having or forming a pumped active region 310, which is interrupted-that is, where the QW(s) removed (as described with respect to the process flow 110)-at NAM facets, such as a front facet (or "FM") 320 at the front of the device, and at a back facet (or "BM") 330 at the back of the device. However, optical emitter device 300 may additionally comprise loss structures 340.

In this regard, as noted above, in accordance with the present disclosure, optical emitter devices may incorporate and/or otherwise may be configured to utilize refractive index (RI) based engineering related modifications for brightness enhancement and kink suppression. The loss structures 340 may be designed and/or configured to provide such RI based engineering modification. In particular, the loss structures 340 may be configured for introducing sufficient losses to achieve both brightness enhancement and kink-suppression, and to do so in cost efficient manner. For example, loss structures (e.g., the loss structure 340 as illustrated in Fig. 3, particularly as shown in the closeup view) may comprise only side patterns-that is, on both (or just one) sides of the pumped active region (e.g., the pumped active region 310 in the optical emitter device 300), along at least a portion of the length of the active region. Implementing such loss structures may require only a minimum of two repetitions of a series of scatterers-that is, features in the loss structures (which in the example embodiment illustrated in Fig. 3 comprise dot-like features).

In the embodiment illustrated in Fig. 3, the scatterers are implemented via etching of the active region followed by overgrowth and are present along the entire length of the device. In this specific example, dots are selectively etched to remove the quantum well of the device on a bottom epi wafer. Consequently, the full wafer surface is overgrown to obtain the final complete epi structure, resulting in a final surface with minimum topography compared to possible alternative implementations requiring deep trenches. This is, the exact same process that may be used for realizing non-absorbing mirrors (NAMs) on the front and back facets of the emitters, as described in United State Patent Application No. 17/249,916, filed on March 18, 2021, which is incorporated herein by reference in its entirety. The reduced topography and the absence of special passivation requirements may be significative advantages of this approach.

Various aspects of the loss structures may be set or adjusted to achieve desired performance with respect to the brightness enhancement and kink suppressions. For example, with reference to the embodiment illustrated in Fig. 3, an estimated refractive index (RI) variation (difference) of at least 0.0001 (e.g., ∼0.003) between regions with and without active region may be sufficient to introduce losses to the modes responsible for the power kinks visible in un-patterned devices. Further, a minimum of two series of scatterers may be needed to completely suppress the kinks, with complete removal of the active region on the emitter side or a single scatterer line resulting in reduction but not complete removal of the discontinuities in the light-current (LI) curve of the device.

Similarly, various characteristics of the loss structures (scatterers) may be set or adjusted to achieve desired performance with respect to the brightness enhancement and kink suppressions. Such characteristics may comprise parameters relating to the features themselves (e.g., dimensions thereof), spacing, fill factors, etc. In this regard, as used herein, spacing comprises spacing (distance) between the lines in the loss structures, spacing (distance) between the repeated features within each line in implementations where non-solid lines are used, and/or spacing (distance) between the loss structures and the pumped active region.

For example, with regards to the dimensions and spacing of the scatterers, when using a design similar to the one illustrated in Fig. 3, desired performance may be achieved by use of dots and grooves with widths that are at least half the emitting wavelength (e.g., 2 µm, 3 µm, 4 µm, or larger in devices with emitting wavelengths between 900 and 1000 nm), and with the first row of scatterers placed from the laser pumped active region at least 5 times the emitting wavelength (e.g., 15 µm, 20 µm, 30 µm, 40 µm, or more in devices with emitting wavelengths between 900 and 1000 nm). Moreover, devices with fill factors of at most 85% (e.g., 65%, 72%, 75%, or 80%) may allow for achieving the desired benefits of the proposed solutions.

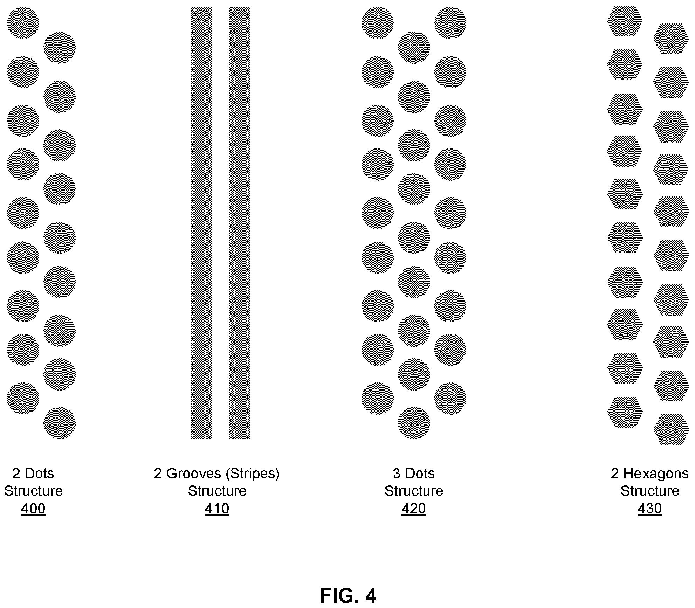

Nonetheless, while the loss structures 340 are illustrated as having a particular design-that is, two rows on each side of dot-shaped scatterers meeting particular spacing criteria-this disclosure is not limited to such an approach. Rather, solutions in accordance with the present disclosure allow for flexibility in the design of the side scatterers, with different designs (e.g., rows of dots, stripes, etc.), and the possibility of varying the depth of the scatterers, periodicity, spacing within the loss structures, and the distance between the loss structures and the pumped active region while maintaining the desired benefits of the proposed solutions. Alternative loss structures are illustrated in and described with respect to Fig. 4.

Use of NAM loss structures, as described herein, may offer considerable advantages, such as with respect to the cost and adaptability. In this regard, adding such loss structures would not require significant (if any) increase in cost since the NAM process is already used for front and back facet reliability, and would not require any additional process or lithographic steps to add the structures. Further, the same structures may work just as well with deeper etches (with or without active region removal and with or without overgrowth), as long as the fabricated scatterers introduce a refractive index variation equal or larger than variation (difference) of at least 0.0001 (e.g., ∼0.003).

Fig. 4 illustrates different example loss structures that may be used in optical emitter devices with non-absorbing mirror (NAM). Shown in Fig. 4 are loss structures 400, 410, 420, and 430.

The loss structures may typically comprise two or more lines of features. The lines may be solid (continuous) lines or may be lines of features spaced (e.g., at a particular same distance). In this regard, when non-solid lines are used, any suitable shape may be used. Various aspects and/or characteristics of the loss structures may be set or adjusted to optimize performance. For example, the number of lines used in the loss structures may be adaptively selected, such as to optimize performance. Further, the spacing between the lines (and/or in implementations where non-solid lines are used, the spacing between the repeated features in each line), and/or spacing from the light emitting region may be set or adjusted to optimize performance. In addition, in some instances, in implementations where non-solid lines are used, the lines may be arranged such that repeated features may be staggered.

For example, as illustrated in Fig. 4, the loss structure 400 comprises two lines of dot features (or simply "dots"), with the dot features staggered in the two lines as shown in Fig. 4). The loss structure 410 comprises two solid (continuous) lines. The loss structure 420 comprises three lines of dot features (or simply "dots"), with the dot features staggered in the three lines as shown in Fig. 4). The loss structure 430 comprises two lines of hexagonal dots. Other shapes and/or number of lines are possible.

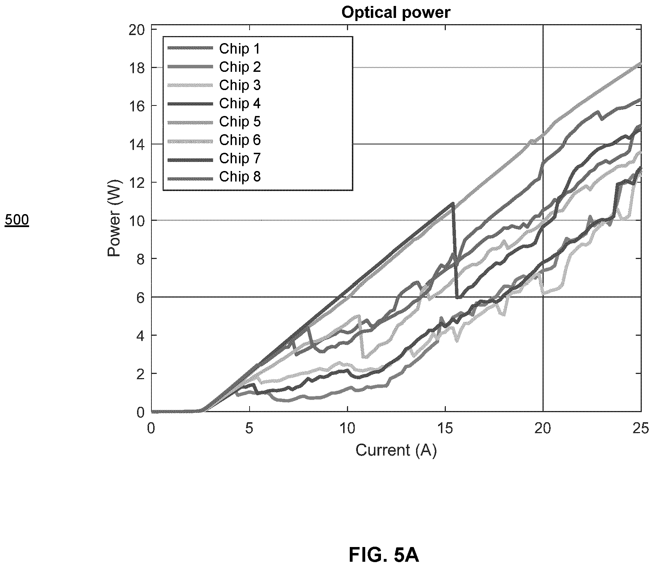

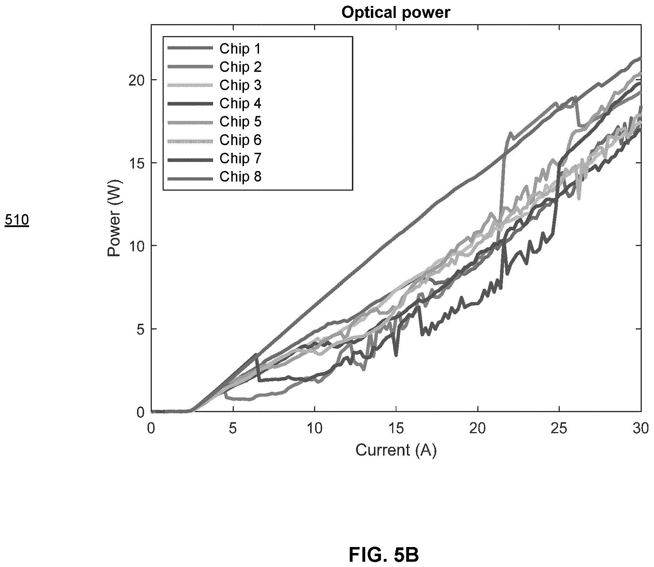

In operation, NAM loss structures with dots rows and/or multiple grooves, such as those illustrated in Fig. 4, may demonstrate improved kink suppression behavior. For example, devices with a fill factor in excess of, e.g., 50% may exhibit clear discontinuities in the power-current characteristic, for both continuous wave (CW) and pulsed/quasi-continuous wave (qCW) measurements in absence of loss structures inhibiting the propagation of high order modes. Conversely, the introduction of NAM loss structures (scatterers) results in continuous, kink-free and reproducible power curves, under both measurement conditions. Further, the NAM loss structures may significantly improve and stabilize the slow axis divergence of the emitter far field. This is illustrated in the graphs in Figs. 5A-8.

Figs. 5A-5B are graphs illustrating optical power performance of example optical emitter devices with no refractive index engineering on emitter sides. Shown in Figs. 5A-5B are graphs 500 and 510 illustrating optical power performance of optical emitter devices with no refractive index engineering.

Each of the graphs 500 and 510 comprises data representing optical power of optical chips. In this regard, each of the graphs 500 and 510 comprises a plurality of plots that corresponds to a plurality of different chips (e.g., chips 1-8), with each of the plots comprising data points representing optical power in Watts (W) (y-axis) as a function of current in Amperes (A) (x-axis). In this regard, graph 500 comprises data corresponding to continuous-wave (CW) operation whereas graph 510 comprises data corresponding to quasi-continuous-wave (qCW) operation. The chips 1-8 may incorporate different wafer designs, but all lack the loss structures as described herein-that is, no refractive index engineering on emitter sides.

As illustrated in graphs 500 and 510, designs with no refractive index engineering on emitter sides exhibit considerable kinks (discontinuities) in light-current (LI) curves-that is, jumps in the power, in both continuous-wave (CW) and quasi-continuous-wave (qCW) operations.

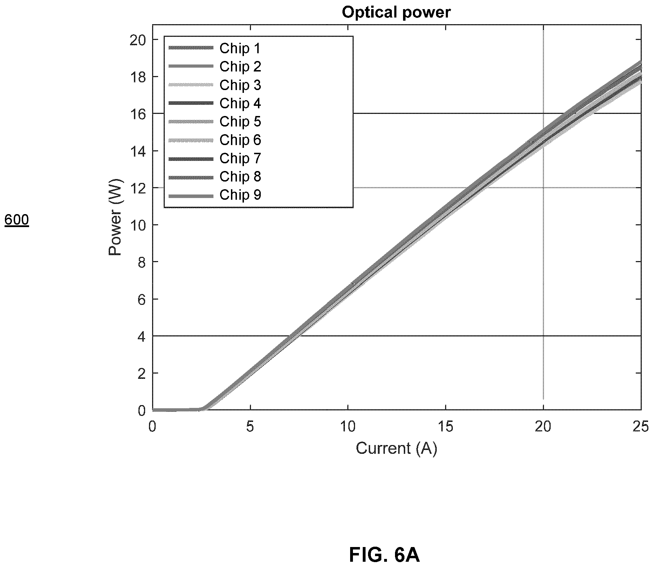

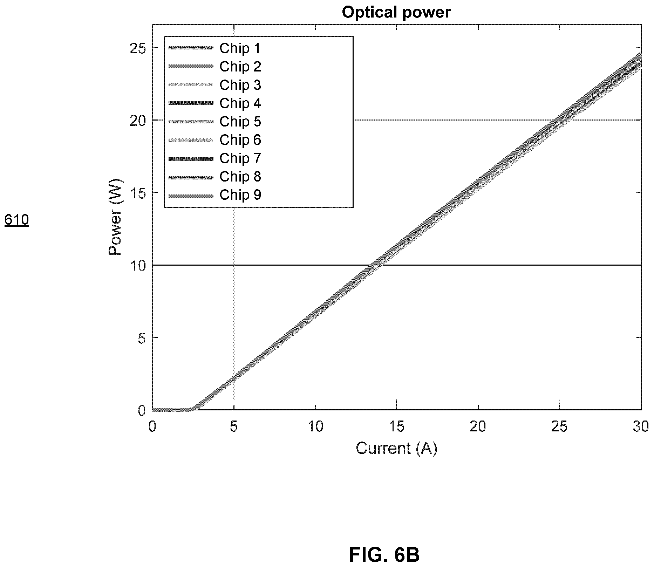

Figs. 6A-6B are graphs illustrating optical power performance of example optical emitter devices with patterned refractive index variations on emitter sides. Shown in Figs. 6A-6B are graphs 600 and 610 illustrating optical power performance of optical emitter devices with refractive index engineering.

Each of the graphs 600 and 610 comprises data representing optical power of optical chips. In this regard, each of the graphs 600 and 610 comprises a plurality of plots that corresponds to a plurality of different chips (e.g., chips 1-9), with each of the plots comprising data points representing optical power in Watts (W) (y-axis) as a function of current in Amperes (A) (x-axis). The chips 1-9 may incorporate different wafer designs that comprise use of loss structures as described herein. For example, the similarly named chips in Figs. 5A-5B and 6A-6B have the same wafer and fill factor as previous slide, but with added loss structures as described herein.

As illustrated in graphs 600 and 610 (particularly viewed relative to graphs 500 and 510 of Figs. 5A-5B), designs introducing patterned refractive index variations show no detectable kinks in light light-current (LI) curves, in both continuous-wave (CW) and quasi-continuous-wave (qCW) operations.

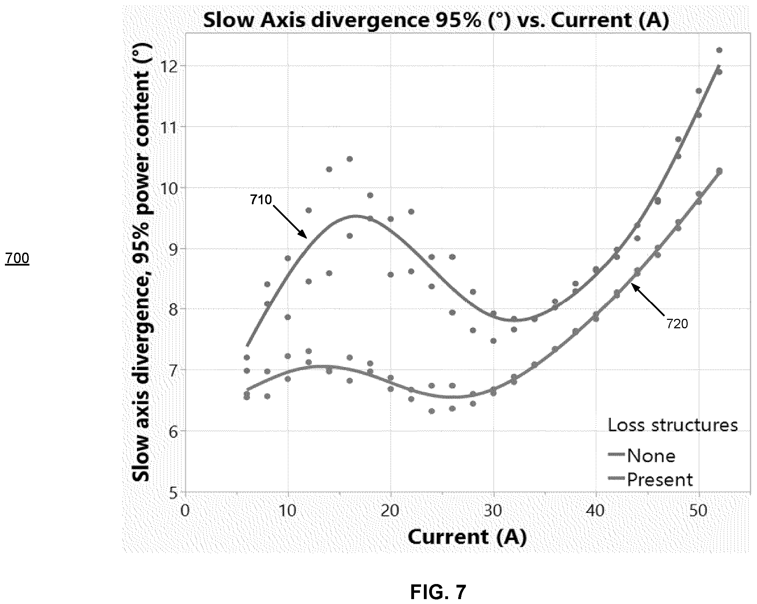

Fig. 7 is a graph illustrating improvements in slow axis divergence performance when using loss structures. Shown in Fig. 7 is graph 700 illustrating slow axis divergence at 95% power content of an optical emitter device.

The graph 700 comprises data representing slow axis divergence of an optical emitter device (laser). In this regard, the graph 700 includes plots 710 and 720, each comprising data points representing slow axis divergence angles (95% power content) in degrees (°) (y-axis) as a function of current in Amperes (A) (x-axis), with plot 710 corresponding to an optical emitter device without loss structures and plot 720 corresponding to an optical emitter device with structured NAM-e.g., a laser emitter with NAMs and side loss structures-implemented in accordance with the present disclosure.

The graph 700 illustrates the improvement to far field slow axis divergence as a result of use of NAM loss structures in an optical emitter device (e.g., emitter) with respect to the same device without loss structures. In other words, the data points captured in graph 700 allow for comparison in performance using devices with the same epi structure, cavity length, fill factor, width and coating of the pumped active region, to demonstrate the improvement resulting from use of NAM loss structures.

In this regard, the data used in generating the graph 700 may be obtained by use of devices with the same chip dimensions with NAMs, but with or without side loss structures, to allow for comparison between use of loss structures and no use of such structures. As illustrated by the graph 700, slow axis divergence at both low and high currents shows a marked improvement for the device with NAM and loss structures (e.g., side loss structures) compared to a similar device but without loss structures. In particular, as illustrated by plots 710 and 720, use of NAM with loss structures results in improved performance with respect to slow axis divergence angles (95%). For example, at a current of 46 A, the device with NAM and loss structures provides a slow axis divergence (angle) that is 0.9° narrower than a similar device (e.g., same epi structure, cavity length, fill factor, width and coating of the pumped active region, etc.) while also stabilizing the far field at low current values.

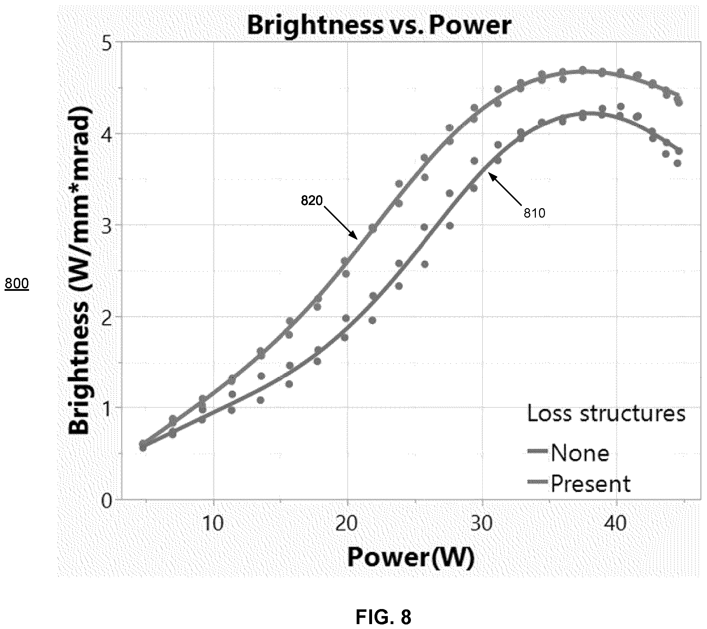

Fig. 8 is a graph illustrating improvements in brightness performance when using loss structures. Shown in Fig. 8 is graph 800 illustrating brightness performance of an optical emitter device.

The graph 800 comprises data representing brightness of an optical emitter device (laser). In this regard, the graph 800 includes plots 810 and 820, each comprising data points representing brightness in W/mm*mrad (y-axis) as a function of power in watts (W) (x-axis), with plot 810 corresponding to an optical emitter device without loss structures and with plot 820 corresponding to an optical emitter device with structured NAM-e.g., laser emitter with NAMs and side loss structures-implemented in accordance with present disclosure.

In this regard, the data used in generating the graph 800 may be obtained by use of devices with the same chip dimensions with NAMs, but with or without side loss structures, to allow for comparison between use of loss structures and no use of such structures. As illustrated in the graph 800 (the plots 810 and 820), use of NAM with loss structures results in improved performance with respect to device brightness. In particular, the loss structures introduced with the NAM process may result in a considerable enhancement of the laser brightness across the whole current range. For example as illustrated in graph 800, the device brightness may be increased by roughly 13% at a rating of 40W.

An example optical emitter device, in accordance with the present disclosure, comprises: a first region comprising a first semiconductor material; an active region located on the first region, wherein the active region comprises a pumped active region between a front end and a back end of the optical emitter device; and a plurality of loss structures arranged along at least a portion of at least one side of the pumped active region.

In an example embodiment, the plurality of loss structures is arranged between the front end and the back end of the optical emitter device.

In an example embodiment, the plurality of loss structures comprises two or more continuous etched lines.

In an example embodiment, the plurality of loss structures comprises two or more lines of discontinuous etched features.

In an example embodiment, the discontinuous features comprise dot-like etched indentations.

In an example embodiment, the plurality of loss structures comprises two or more lines or rows, and wherein a width of each line or row is at least half an emitting wavelength of the optical emitter device.

In an example embodiment, the plurality of loss structures comprises two or more lines or rows, and wherein a first line or row of the plurality of loss structures is spaced at a distance of at least 5 times an emitting wavelength of the optical emitter device.

In an example embodiment, the plurality of loss structures is configured to yield a fill factor of no more than 85%.

In an example embodiment, the plurality of loss structures comprises a first plurality of loss structures and a second plurality of loss structures, and wherein the first plurality of loss structures of and the second plurality of loss structures are arranged on different sides relative to the pumped active region.

In an example embodiment, the first plurality of loss structures and the second plurality of loss structures are identical.

In an example embodiment, the first plurality of loss structures differs from the second plurality of loss structures with respect to at least one parameter or characteristic.

In an example embodiment, the plurality of loss structures is configured to ensure meeting predetermined optical performance criteria.

In an example embodiment, the optical performance criteria comprise yielding a refractive index (RI) variation of at least 0.0001 for regions incorporating the plurality of loss structures.

In an example embodiment, the plurality of loss structures is configured to scatter light emitted in one or more directions other than through the front end and back end of the optical emitter device.

In an example embodiment, the active region comprises a quantum well (QW).

In an example embodiment, the optical emitter device is an edge-emitting laser device.

An example method of making an optical emitter device, in accordance with the present disclosure, comprises: growing a first portion that comprises a first region and an active region, wherein the first region comprises a first semiconductor material, and wherein the active region is located on the first region; subsequently, selectively etching the active region to form a pumped active region between a front end and a back end of the optical emitter device; and etching a plurality of loss structures along at least a portion of at least one side of pumped active region.

In an example embodiment, the method further comprises arranging the plurality of loss structures between the front end and the back end of the optical emitter device.

In an example embodiment, etching the plurality of loss structures comprises etching two or more continuous etched lines.

In an example embodiment, etching the plurality of loss structures comprises etching two or more lines of discontinuous etched features.

In an example embodiment, the plurality of loss structures comprises two or more lines or rows, and further comprising etching the plurality of loss structures such that a width of each line or row is at least half an emitting wavelength of the optical emitter device In an example embodiment, the plurality of loss structures comprises two or more lines or rows, and wherein etching the plurality of loss structures comprises etching a first line or row of the plurality of loss structures at a distance of at least 5 times an emitting wavelength of the optical emitter device.

In an example embodiment, the method further comprises etching the plurality of loss structures to yield a fill factor of no more than 85%.

In an example embodiment, etching the plurality of loss structures comprises etching a first plurality of loss structures and a second plurality of loss structures, and wherein the first plurality of loss structures of and the second plurality of loss structures are arranged on different sides relative to the pumped active region.

In an example embodiment, the first plurality of loss structures and the second plurality of loss structures are identical.

In an example embodiment, the first plurality of loss structures differs from the second plurality of loss structures with respect to at least one parameter or characteristic.

In an example embodiment, the method further comprises configuring the plurality of loss structures to ensure meeting predetermined optical performance criteria.

In an example embodiment, the optical performance criteria comprise yielding a refractive index (RI) variation of at least 0.0001 for regions incorporating the plurality of loss structures.

In an example embodiment, the method further comprises configuring the plurality of loss structures is configured to scatter light emitted in one or more directions other than through the front end and back end of the optical emitter device.

In an example embodiment, the method further comprises configuring at least a portion of the active region as a quantum well (QW).

In the following, a set of aspects is disclosed. The aspects are numbered to facilitate referencing the features of one aspect in other aspects. The aspects form part of the disclosure of the present application and could be made subject to independent and/or dependent claims irrespective of what currently is claimed in the application. The aspects are:
1. An optical emitter device comprising:
   a first region comprising a first semiconductor material;
   an active region located on the first region, wherein the active region comprises a pumped active region between a front end and a back end of the optical emitter device; and
   a plurality of loss structures arranged along at least a portion of at least one side of the pumped active region.
2. The optical emitter device of aspect 1, wherein the plurality of loss structures is arranged between the front end and the back end of the optical emitter device.
3. The optical emitter device of aspect 1, wherein the plurality of loss structures comprises two or more continuous etched lines.
4. The optical emitter device of claim 1, wherein the plurality of loss structures comprises two or more lines of discontinuous etched features.
5. The optical emitter device of aspect 4, wherein the discontinuous features comprise dot-like etched indentations.
6. The optical emitter device of aspect 1, wherein the plurality of loss structures comprises two or more lines or rows, and wherein a width of each line or row is at least half an emitting wavelength of the optical emitter device.
7. The optical emitter device of aspect 1, wherein the plurality of loss structures comprises two or more lines or rows, and wherein a first line or row of the plurality of loss structures is spaced at a distance of at least 5 times an emitting wavelength of the optical emitter device.
8. The optical emitter device of aspect 1, wherein the plurality of loss structures is configured to yield a fill factor of no more than 85%.
9. The optical emitter device of aspect 1, wherein the plurality of loss structures comprises a first plurality of loss structures and a second plurality of loss structures, and wherein the first plurality of loss structures of and the second plurality of loss structures are arranged on different sides relative to the pumped active region.
10. The optical emitter device of aspect 9, wherein the first plurality of loss structures and the second plurality of loss structures are identical.
11. The optical emitter device of aspect 9, wherein the first plurality of loss structures differs from the second plurality of loss structures with respect to at least one parameter or characteristic.
12. The optical emitter device of aspect 1, wherein the plurality of loss structures is configured to ensure meeting predetermined optical performance criteria.
13. The optical emitter device of aspect 12, wherein the optical performance criteria comprise yielding a refractive index (RI) variation of at least 0.0001 for regions incorporating the plurality of loss structures.
14. The optical emitter device of aspect 1, wherein the plurality of loss structures is configured to scatter light emitted in one or more directions other than through the front end and back end of the optical emitter device.
15. The optical emitter device of aspect 1, wherein the active region comprises a quantum well (QW).
16. The optical emitter device of aspect 1, wherein the optical emitter device is an edge-emitting laser device.
17. A method of making an optical emitter device, the method comprising:
   growing a first portion that comprises a first region and an active region, wherein the first region comprises a first semiconductor material, and wherein the active region is located on the first region;
   subsequently, selectively etching the active region to form a pumped active region between a front end and a back end of the optical emitter device; and
   etching a plurality of loss structures along at least a portion of at least one side of pumped active region.
18. The method of aspect 17, further comprising arranging the plurality of loss structures between the front end and the back end of the optical emitter device.
19. The method of aspect 17, wherein etching the plurality of loss structures comprises etching two or more continuous etched lines.
20. The method of aspect 17, wherein etching the plurality of loss structures comprises etching two or more lines of discontinuous etched features.
21. The method of aspect 17, wherein the plurality of loss structures comprises two or more lines or rows, and further comprising etching the plurality of loss structures such that a width of each line or row is at least half an emitting wavelength of the optical emitter device.
22. The method of aspect 17, wherein the plurality of loss structures comprises two or more lines or rows, and wherein etching the plurality of loss structures comprises etching a first line or row of the plurality of loss structures at a distance of at least 5 times an emitting wavelength of the optical emitter device.
23. The method of aspect 17, further comprising etching the plurality of loss structures to yield a fill factor of no more than 85%.
24. The method of aspect 17, wherein etching the plurality of loss structures comprises etching a first plurality of loss structures and a second plurality of loss structures, and wherein the first plurality of loss structures of and the second plurality of loss structures are arranged on different sides relative to the pumped active region.
25. The method of aspect 24, wherein the first plurality of loss structures and the second plurality of loss structures are identical.
26. The method of aspect 24, wherein the first plurality of loss structures differs from the second plurality of loss structures with respect to at least one parameter or characteristic.
27. The method of aspect 17, further comprising configuring the plurality of loss structures to ensure meeting predetermined optical performance criteria.
28. The method of aspect 27, wherein the optical performance criteria comprise yielding a refractive index (RI) variation of at least 0.0001 for regions incorporating the plurality of loss structures.
29. The method of aspect 17, further comprising configuring the plurality of loss structures is configured to scatter light emitted in one or more directions other than through the front end and back end of the optical emitter device.
30. The method of aspect 17, further comprising configuring at least a portion of the active region as a quantum well (QW).

The present application claims priority of U.S. Patent Application No. 18/790,359 filed on July 31, 2024. The entire disclosure of this application is hereby explicitly incorporated by reference into the present application.

Implementations disclosed herein may relate to the following: Systems and methods are provided for refractive index engineering for brightness enhancement and kink suppression in optical emitter devices. An example optical emitter device may include a first region that includes a first semiconductor material, an active region located on the first region, with the active region including a pumped active region between a front end and a back end of the optical emitter device, and a plurality of loss structures arranged along at least a portion of at least one side of the pumped active region. The plurality of loss structures may be arranged between the front end and the back end of the optical emitter device. The plurality of loss structures may include two or more continuous etched lines. The plurality of loss structures may include two or more discontinuous etched features.

As utilized herein, "and/or" means any one or more of the items in the list joined by "and/or". As an example, "x and/or y" means any element of the three-element set {(x), (y), (x, y)}. In other words, "x and/or y" means "one or both of x and y." As another example, "x, y, and/or z" means any element of the seven-element set {(x), (y), (z), (x, y), (x, z), (y, z), (x, y, z)}. In other words, "x, y and/or z" means "one or more of x, y, and z." As utilized herein, the term "exemplary" means serving as a non-limiting example, instance, or illustration. As utilized herein, the terms "for example" and "e.g." set off lists of one or more non-limiting examples, instances, or illustrations.

While the present method and/or system has been described with reference to certain implementations, it will be understood by those skilled in the art that various changes may be made and equivalents may be substituted without departing from the scope of the present method and/or system. In addition, many modifications may be made to adapt a particular situation or material to the teachings of the present disclosure without departing from its scope. Therefore, it is intended that the present method and/or system not be limited to the particular implementations disclosed, but that the present method and/or system will include all implementations falling within the scope of the appended claims.

## Claims

1. An optical emitter device comprising:
a first region comprising a first semiconductor material;
an active region located on the first region, wherein the active region comprises a pumped active region between a front end and a back end of the optical emitter device; and
a plurality of loss structures arranged along at least a portion of at least one side of the pumped active region.

2. The optical emitter device of claim 1, wherein the plurality of loss structures is arranged between the front end and the back end of the optical emitter device.

3. The optical emitter device of any one of the preceding claims, wherein the plurality of loss structures comprises two or more continuous etched lines.

4. The optical emitter device of any one of the preceding claims, wherein the plurality of loss structures comprises two or more lines of discontinuous etched features, wherein, optionally, the discontinuous features comprise dot-like etched indentations.

5. The optical emitter device of any one of the preceding claims, wherein the plurality of loss structures comprises two or more lines or rows, and wherein
a) a width of each line or row is at least half an emitting wavelength of the optical emitter device, and/or
b) the plurality of loss structures comprises two or more lines or rows, and wherein a first line or row of the plurality of loss structures is spaced at a distance of at least 5 times an emitting wavelength of the optical emitter device.

6. The optical emitter device of any one of the preceding claims, wherein the plurality of loss structures is configured to yield a fill factor of no more than 85%.

7. The optical emitter device of any one of the preceding claims, wherein the plurality of loss structures comprises a first plurality of loss structures and a second plurality of loss structures, and wherein the first plurality of loss structures of and the second plurality of loss structures are arranged on different sides relative to the pumped active region, and wherein, optionally,
a) the first plurality of loss structures and the second plurality of loss structures are identical, or
b) the first plurality of loss structures differs from the second plurality of loss structures with respect to at least one parameter or characteristic.

8. The optical emitter device of any one of the preceding claims, wherein the plurality of loss structures is configured to ensure meeting predetermined optical performance criteria, and wherein, optionally, the optical performance criteria comprise yielding a refractive index (RI) variation of at least 0.0001 for regions incorporating the plurality of loss structures.

9. The optical emitter device of any one of the preceding claims, wherein the plurality of loss structures is configured to scatter light emitted in one or more directions other than through the front end and back end of the optical emitter device.

10. The optical emitter device of any one of the preceding claims, wherein the active region comprises a quantum well (QW).

11. The optical emitter device of any one of the preceding claims, wherein the optical emitter device is an edge-emitting laser device.

12. A method of making an optical emitter device, the method comprising:
growing a first portion that comprises a first region and an active region, wherein the first region comprises a first semiconductor material, and wherein the active region is located on the first region;
subsequently, selectively etching the active region to form a pumped active region between a front end and a back end of the optical emitter device; and
etching a plurality of loss structures along at least a portion of at least one side of pumped active region.

13. The method of claim 12,
a) further comprising arranging the plurality of loss structures between the front end and the back end of the optical emitter device, and/or
b1) wherein etching the plurality of loss structures comprises etching two or more continuous etched lines, or
b2) wherein etching the plurality of loss structures comprises etching two or more lines of discontinuous etched features, and/or
c) further comprising etching the plurality of loss structures to yield a fill factor of no more than 85%, and/or
d) wherein etching the plurality of loss structures comprises etching a first plurality of loss structures and a second plurality of loss structures, and wherein the first plurality of loss structures of and the second plurality of loss structures are arranged on different sides relative to the pumped active region, wherein, optionally,
d1) the first plurality of loss structures and the second plurality of loss structures are identical, or
d2) the first plurality of loss structures differs from the second plurality of loss structures with respect to at least one parameter or characteristic, and/or
e) further comprising configuring the plurality of loss structures to ensure meeting predetermined optical performance criteria, wherein, optionally, the optical performance criteria comprise yielding a refractive index (RI) variation of at least 0.0001 for regions incorporating the plurality of loss structures, and/or
f) further comprising configuring the plurality of loss structures is configured to scatter light emitted in one or more directions other than through the front end and back end of the optical emitter device, and/or
g) further comprising configuring at least a portion of the active region as a quantum well (QW).

14. The method of claim 12 or 13, wherein the plurality of loss structures comprises two or more lines or rows, and further comprising etching the plurality of loss structures such that a width of each line or row is at least half an emitting wavelength of the optical emitter device.

15. The method of any one of claims 12 to 14, wherein the plurality of loss structures comprises two or more lines or rows, and wherein etching the plurality of loss structures comprises etching a first line or row of the plurality of loss structures at a distance of at least 5 times an emitting wavelength of the optical emitter device.
